# EUROPEAN PATENT SPECIFICATION

(11) **EP 2 274 771 B1**
(45) Date of publication and mention of the grant of the patent: **15.07.2015**
(21) Application number: 09758837.0
(22) Date of filing: 11.03.2009
(51) Int. Cl.: H01L 21/44, C23C 14/28, C23C 14/08, H01S 3/00, H01S 3/23, C23C 14/56

(54) **A METHOD FOR FABRICATING THIN FILMS**
VERFAHREN ZUR HERSTELLUNG VON DÜNNFILMEN
PROCÉDÉ POUR LA FABRICATION DE FILMS MINCES

(30) Priority: 27.03.2008 US 39883 P; 20.10.2008 US 254076
(43) Date of publication of application: 19.01.2011
(73) Proprietor: Imra America, Inc., Ann Arbor, MI 48105 (US)
(72) Inventor: MURAKAMI, Makoto, Ann Arbor, MI 48103 (US); HU, Zhendong, Ann Arbor, MI 48105 (US); LIU, Bing, Ann Arbor, MI 48108 (US); CHE, Yong, Ann Arbor, MI 48105 (US); LIU, Zhenlin, Ann Arbor, MI 48105 (US); UEHARA, Yuzuru, 472-0007 Aichi (JP)
(74) Representative: Epping - Hermann - Fischer
(86) International application number: PCT/US2009/036789
(87) International publication number: WO 2009/148674

(56) References cited:
- DE-A1- 4 229 399
- US-A- 4 987 007
- US-A1- 2001 009 250
- US-A1- 2005 167 405
- US-A1- 2005 212 906
- US-A1- 2005 226 287
- US-A1- 2008 006 524
- US-B1- 6 312 768
- ANONYMOUS: "Reduction of particulates in laser ablated high Tc thin films by laser-induced plume heating", RESEARCH DISCLOSURE, MASON PUBLICATIONS, HAMPSHIRE, GB, vol. 320, no. 94, 1 December 1990 (1990-12-01), XP007115881, ISSN: 0374-4353

## Description

### Field of the Invention

This invention is related to pulsed laser deposition (PLD) using a pulsed laser to fabricate thin-film materials on a substrate.

### Background

Nano-technology is one of the key technologies for future scientific applications. Fabrication and modification of nano-materials are demanded in many fields of nanoscience. Pulsed laser deposition (PLD) has been extensively used as a fabrication technique to grow nano-particles, nano-rods, nano-wires, and thin films of both inorganic and organic materials. High-quality thin films and nano-structures of various materials, such as metals, semiconductors, insulators, and superconductors, have been successfully grown using PLD. Conventional PLD methods mostly employ nanosecond pulsed lasers such as excimer lasers and Q-switched Nd:YAG lasers. In the nanosecond PLD approach, the resultant nanoparticles often have a wide size distribution ranging from a few nanometers to a few hundreds of nanometers. The major drawbacks of this technique include unavoidable formation of very large (micron-sized) droplets due to splashing of the laser-melted target. To overcome the problem of droplet formation, ultrashort pulsed lasers with pulse durations in the picosecond to femtosecond range have been suggested as an alternative laser source for PLD. In recent years, ultrashort PLD has attracted much attention due to the commercial availability of robust ultrashort pulsed lasers.

Because of the extremely short pulse duration and the resultant high peak power density provided by ultrashort pulsed lasers, ultrashort PLD is distinguished from the nanosecond PLD in several aspects. First, the ablation threshold is reduced by 1-2 orders of magnitude. This means that the total pulse energy for ablation can be reduced by the same order of magnitude. For example, typical nanosecond pulse energy is a few hundred milli-Joules, while an ultrashort pulsed laser with micro-Joule pulses can achieve the same level of ablation. Second, the heat affected zone is significantly reduced, which in turn provides an opportunity of high resolution laser machining and also reduces droplet formation in material deposition. Recently, several theoretical and experimental studies have shown that ultrashort PLD can also generate nanoparticles. (See "Cluster emission under femtosecond laser ablation of silicon", A. V. Bulgakov, I. Ozerov, and W. Marine, Thin Solid Films Vol. 453, 557-561, 2004; "Synthesis of nanoparticles with femtosecond laser pulses", S. Eliezer, N. Eliaz, E. Grossman, D. fisher, I. Couzman, Z. Henis, S. Pecker, Y. Horovitz, M. Fraenkel, S. Maman, and Y. Lereah , Physical Review B, Vol. 69, 144119, 2004; "Generation of silicon nanoparticles via femtosecond laser ablation in vacuum", S. Amoruso, R. Bruzzese, N. Spinelli, R. Velotta, M. Vitiello, X. Wang, G. Ausanio, V. Iannotti, and Lanotte, Applied Physics Letters, Vol. 84, 4502-4504, 2004.) In particular, in ultrashort pulsed laser ablation, nanoparticles are generated automatically as a result of phase transition near the critical point of the material under irradiation, which is only reachable through ultrashort heating. Thus, both nanoparticles and nanocomposite films, i.e., nanoparticle-assembled films, can be deposited onto substrates using the ultrashort PLD method.

For extensive application of ultrashort PLD, it is also desirable to have the ability of growing smooth thin films free of particles. However, problems have been encountered here due to the same automatic particle generation phenomenon mentioned above, and the reported growth results have shown films with very rough surfaces due to particle aggregation (See "Cluster emission under femtosecond laser ablation of silicon", A. V. Bulgakov, I. Ozerov, and W. Marine, Thin Solid Films Vol. 453, 557-561, 2004.). One reported approach was to use high repetition rate low pulse energy lasers for ablation. See for example the reports: "Ultrafast ablation with high pulse rate lasers, Part I: Theoretical considerations", E. G. Gamaly, A. V. Rode, B. Luther-Davies, Journal of Applied Physics, Vol 85, 4213, 1999; "Ultrafast ablation with high pulse rate lasers, Part II: Experiments on laser deposition of amorphous carbon films", E. G. Gamaly, A. V. Rode, B. Luther-Davies, Journal of Applied Physics, Vol. 85, 4222, 1999, and "Picosecond high repetition rate pulsed laser ablation of dielectric: the effect of energy accumulation between pulses", B. Luther-Davies, A. V. Rode, N. R. Madsen, E. G. Gamaly, Optical Engineering, Vol. 44, 055102, 2005. Similarly, in US 6,312,768 B1 (by the same authors/inventors), a solid state pulsed laser with a pulse duration of 60 ps, a pulse energy of tens of nano-Joule, and a repetition rate of 76 MHz is used for ablation and deposition. In particular, each pulse energy is sufficiently low (below the single shot ablation threshold) to avoid particle formation, while the very high repetition rate results in accumulation of heat on the target surface such that the target surface temperature can be raised to above its melting point after a sufficient number of pulses and the material is removed essentially by thermal evaporation.

In the field of laser machining, there are also several advantages of high repetition rate ultrashort laser ablation based on the heat accumulation effect. In this field, patent US 6,552,301,B2 provides a method for precise laser machining, where ablation with 'bursts' of ultrashort laser pulses is used to achieve a so-called 'gentle' ablation to reduce undesired effects such as poor morphology of the machined features.

However, for applications in material synthesis, these methods are limited to those target materials with very low thermal conductivity and low ablation threshold. For many materials, for example metals, the heat conductivity is too high to build up a sufficient high surface temperature, while for most metal oxides the ablation threshold is too high for nano-Joule pulse ablation to occur.

For metals, one success of ultrashort PLD was reported using the Free Electron Laser at the Thomas Jefferson National Accelerator Facility (See "Pulsed laser deposition with a high average power free electron laser: Benefits of subpicosecond pulses with high repetition rate", A. Reilly, C. Allmond, S. Watson, J. Gammon and J. G. Kim, Journal of Applied Physics, Vol. 93, 3098, 2003.). The free electron laser provides femtosecond infrared pulses with a high repetition rate up to 78 MHz, and the pulse energy is in the micro-Joule region. Smooth Ni₈₀Fe₂₀ alloy films have been deposited. However, wide application of a free-electron laser in industrial thin film growth is practically impossible, considering the size of the facility and the running cost.

Based on the inventors' previous systematic investigation of ultrashort pulsed laser ablation and deposition, a patent application (US 60/818289) and a publication (See "Nanoparticle generation in ultrafast pulsed laser ablation of nickel", B. Liu, Z. Hu, Y. Chen, X. Pan, and Y. Che, Applied Physics Letters, Vol. 90, 044103, 2007) were disclosed recently, in which the experimental parameters for single shot (i.e., in the low repetition regime in kHz) laser ablation were described to obtain nanoparticles and to grow nanoparticle aggregate thin films. Basically the authors found that for ablation barely above threshold, the ablated materials mostly exist in the form of nanoparticles. In addition, by supplying reactive background gases (e.g., oxygen), compound (e.g., metal oxide) nanoparticles can also be formed.

DE 42 29 399 A1 discloses a laser ablation based deposition process using bursts of laser pulses.

### Summary of the Invention

In one aspect, the present invention expands our previous work in nanoparticle generation with ultrashort pulses. Operation in a "burst mode" provides for growth of thin films of metals, semiconductors, and metal oxides. Each burst includes a train of laser pulses closely separated in time. Pulse parameters, such as the number of pulses in the burst, the burst repetition rate, and the fluence may be varied to provide tunable size control in growth of nanoparticles and nanocomposites.

Experiments showed that by adjusting the time separation between the pulses within each burst, the ablation plume produced by a leading laser pulse can be modified by the subsequent pulses when the separation between pulses is short enough. Although it is not necessary to the practice of embodiments of the present invention to understand the operative mechanism therein, it appears the effect first builds up the charge density in the plume plasma, such that the plasma can block (i.e., absorb and reflect) the rest of the incoming pulses by the plasma shielding effect. This results in laser ablation of the nanoparticles contained in the plume and gradually breaks down the size of the particles.

The present invention provides a pulsed laser deposition method according to claim 1.

An ultrashort pulsed laser is used to fabricate morphology-tunable films, from nanoparticle aggregates to particle-free smooth films using ultrashort PLD. The average size of the particles is controlled by changing the laser parameters such as the number of pulses in each burst, the pulse separation between each pulse, the burst repetition rate, and the laser fluence. Particle sizes decrease as the number of burst pulses and burst repetition rate increase. The processing temperature of the substrate has a minor effect. The results are repeatable even if the substrate temperature varies over a reasonable operating range. In addition, by switching target materials during the deposition, nanocomposites consisting of several materials can be obtained.

The nanoparticle and nanocomposite films can be produced by ablation of targets of semiconductors, metals, and metal oxides. The method is also applicable to metal nitrides, fluorides, arsenides, sulfides and so on, and organic materials insofar as the target is in a solid state. The target can be a single crystal, a ceramic, or a compressed powder. The target packing density is not necessarily very dense. The depositions can be achieved by ablating a target with a packing density as low as 60% of the material's ideal density. This means that the target can be prepared simply by compressing powders without any sintering process. In fact, the demonstrated nanoparticles, nanocomposites and films are fabricated by ablating low density targets as well as high density ceramics targets and single crystal targets.

The films can be nanoparticle-aggregates produced by continuous deposition of nanoparticles; or can be a composite with any combination of materials such as metals, semiconductors, and metal oxides, but not limited in these materials. The nanocomposite films can be produced by alternately or simultaneously depositing nanoparticles and/or smooth thin-film. A variety of material combinations can be easily realized by alternating targets of different materials during deposition.

With certain embodiments of the present invention, the sizes of the nanoparticles are not determined by the temperature of the substrate or the annealing process. The size is mainly controlled by laser parameters, such as number of pulses in each burst, the burst repetition rate, laser fluence (or pulse energy), pulse width, and laser wavelength. Suitable laser parameters include: a pulse width of 10 fs-100 ps,and a laser fluence of about 10 mJ/cm² - 100 J/cm². An exemplary pulse energy may be in the range of about 10 nJ to 100 µJ, 50nJ-100 µJ, or similar ranges, and may typically be in the range of 50 nJ to 10 µJ. There are two repetition rates to consider: the first is the repetition rate of the laser pulses within each burst (also referred to the 'base' repetition rate in the text), and the second is the repetition rate of the burst (referred to as the burst repetition rate). A base repetition rate of 1 MHz-1 GHz and a burst repetition rate from 1 kHz to 10 MHz have been found to be suitable.

In addition to the above laser parameters, the background gas(es) and their pressures also provide additional control over the crystallinity, stoichiometry, and the morphology of the particles and the films. In the current ultrashort PLD process, desired crystallinity and stoichiometry of materials can be realized either by ablating some targets in a background gas of oxygen, nitrogen, argon or a gas mixture of any appropriate processing gases with partial and total pressures.

It is a goal of the invention to achieve one or more of the following objects although the invention may be practiced without the full achievement of any one of these objects.

One object is to obtain a method of pulsed laser deposition of thin-film materials having steps including conducting laser ablation using a burst of laser pulses, wherein each burst contains a pulse-train of laser pulses having at least two pulses with a selected pulse separation to create an interaction between subsequent laser pulse(s) and a plasma generated via the ablation of a target material by previous pulse(s), in a vacuum chamber; and depositing the ablated materials onto a substrate to form thin-films by placing the substrate in the plasma stream generated by the "burst-mode" laser ablation in the vacuum chamber.

A further object is to provide such a method wherein the pulses may have a pulse duration less than 1 ns , preferably less than about 100 ps and/or each of the bursts of the pulse-train may contain 2-200 pulses. The selected pulse separation between individual pulses may be less than about 1 µs, preferably less than about 200 ns.

A still further object is to provide such a method wherein the burst has a repetition rate of 1kHz - 100MHz, and/or at least one laser pulse in the burst has a pulse energy in the range of about 1 nJ - 100 µJ.

A further object is to provide such a method wherein the number of pulses in each burst and the repetition rate of the burst are controlled independently.

A further object is to provide such a method wherein the vacuum chamber contains target and substrate materials, and in which background gas(es) and their pressures are appropriately adjusted.

A further object is to provide such a method wherein an optical system delivers focused laser pulses onto the target surface, enabling a laser fluence in the range 1mJ/cm² -100 J/cm².

A still further object is to provide such a method wherein the vacuum chamber includes a probe to monitor plasma ion current during laser ablation/deposition.

A further object is to provide such a method wherein the pulse separation between pulses and the effect of the said interaction between subsequent laser pulse(s) and the plasma are determined or monitored by measuring the transient or time-averaged plasma ion current.

A further object is to provide such a method wherein the thin-film materials include nanoparticle aggregates, nanoparticle-embedded nanocomposite films, and particle-free and droplet-free smooth films, and/or wherein thin-film morphology is selected by controlling the burst parameters, such as the number of burst pulses and the pulse separation between the pulses in each burst, the burst repetition rate, and the pulse energy of each pulse. The thin-film materials may comprise: a metal, alloy, metal oxide, metal nitride, metal fluoride, metal arsenide, metal sulfide, semiconductor, carbon, glass, polymer, and/or composite material.

Another object is to provide such a method wherein the thin-film materials have a microstructure of amorphous or crystalline phase, or a mixture of both amorphous and crystalline phases, and/or the thin-film materials include solid solutions or nanocomposites or superlattice structures of multimaterials by alternately or simultaneously ablating different target materials.

In the method, the burst may be generated via optical beam splitting and recombining using a beam splitter and a delay stage, or the burst may be achieved via an acousto-optic modulator (AOM) that is used for pulse selection in a chirped pulse amplification (CPA) system, and the burst width and burst repetition rate are determined by the gate width and repetition rate of the AOM, respectively.

Another object is to provide a method of pulsed laser deposition for material synthesis on a substrate, wherein a burst of laser pulses is directed toward an interaction region to cause an initial laser interaction among a target and at least one pulse of the burst, and also to cause a further laser interaction among an emission caused by the initial interaction and at least one subsequent pulse of the burst, the further interaction controllably modifying a physical property of the material synthesized on the substrate material.

A further object is to provide such a method wherein the initial interaction is at least laser ablation, and the emission includes particles detectable with measurement equipment.

In this method, a duration of the burst may be less than about a few microseconds and one or more pulses of the burst may have a pulse width of less than about 100 ps and a temporal spacing in the range of about 1 ns to 1 µs, or one or more of the pulses of the burst may have a pulse width of less than about 10 ps and a temporal spacing in the range of about 1 ns to 1 µs.

A further object is to provide such a method wherein at least two pulses of the burst have different pulse characteristics, at least one pulse characteristic being based on the further interaction, or wherein the burst includes at least two pulses having at least one of a different temporal spacing, a different energy, a different pulse width, and a different peak power.

A still further object is to provide such a method wherein the material synthesis comprises forming a thin film on the substrate, and wherein said physical property is one of a number, size and distribution of particles deposited on the film, the physical property being affected by controlling at least one of a pulse characteristic and burst characteristic.

A further object is to provide such a method wherein at least one of a pulse energy and number of pulses within the burst are controlled in such a way that limits the number of particles on or within the synthesized material so as to produce a substantially particle-free thin film.

A further object is to provide such a method wherein at least some pulses of said burst are generated at a pulse repetition rate in the range of about 1 MHz to about 1 GHz.

A further object is to provide, by any of the aforementioned methods, a product having: a substrate having a substantially particle free thin-film deposited thereon.

Another object of this invention is to provide a system for pulse laser deposition for material synthesis on a substrate, including a substrate manipulator; a target manipulator; a mechanism for generating a burst of laser pulses and for controlling a characteristic of the burst or a characteristic of a pulse of the burst; an optical system to direct the burst toward an interaction region; and a controller connected to the generating mechanism, wherein the system provides for controllable modification of a physical property of the material.

A further object of the invention is to provide such a system wherein one or more of a pulse energy and number of pulses within the burst are controllable in such a way that limits the number of particles on or within the synthesized material so as to produce a substantially particle-free thin film.

Another object of the invention is to provide a method of pulsed laser deposition (PLD) using a burst of laser pulses to fabricate a thin-film material on a substrate.

An additional object of the invention is to provide such a method to produce a thin-film material having a controlled film morphology.

Another object of the invention is to provide a laser system configured to produce a burst of laser output pulses generated at a repetition rate in the range of about 1 MHz to 1 GHz., using at least one of a fiber oscillator and fiber amplifier.

### Brief Description of the Drawings

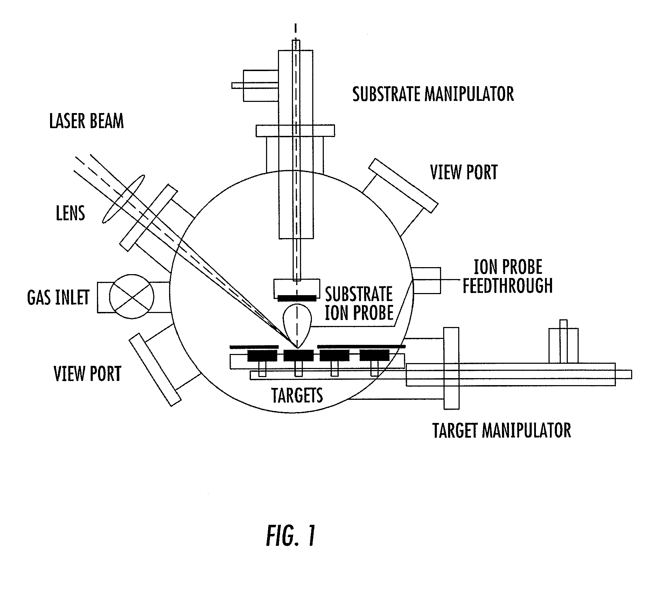

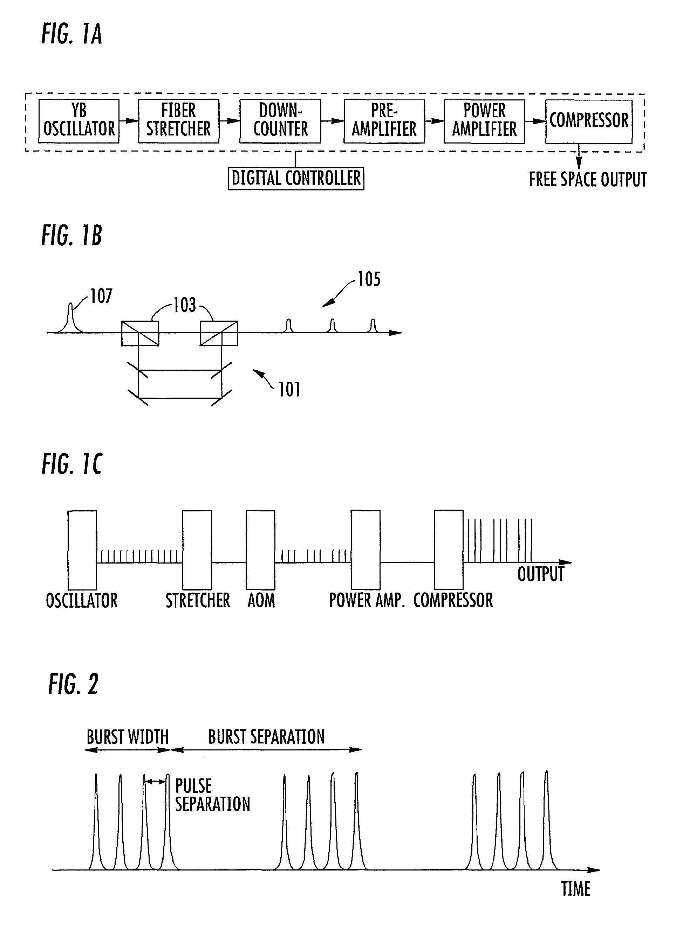

**FIG. 1** schematically illustrates several elements of a pulsed laser deposition system. The system includes a vacuum chamber (and related pumps, not shown in the figure), a target manipulator, an ion probe (Langmuir probe), a gas inlet, and a substrate manipulator. The laser beam is focused onto the target surface through a fused silica window.
**FIGS. 1A-1C** schematically illustrate examples of various laser systems suitable for ultrashort pulse laser deposition (PLD) systems, and particularly for operation in a burst mode.
**FIG. 2** is a schematic illustration of laser pulses in a "burst mode". Each burst contains a group of closely separately pulses. The width of the burst is adjustable so that the bursts can contain a variable number of pulses. For a typical pulse amplification system, the 'base' repetition rate, i.e., the repetition rate of the pulses within the bursts is determined by the oscillator repetition rate, which is possible to change. The burst repetition rate and width are adjusted by, selecting pulses with an optical switch, for example an acousto-optical modulator (AOM) shown in FIGs 1A or 1C.

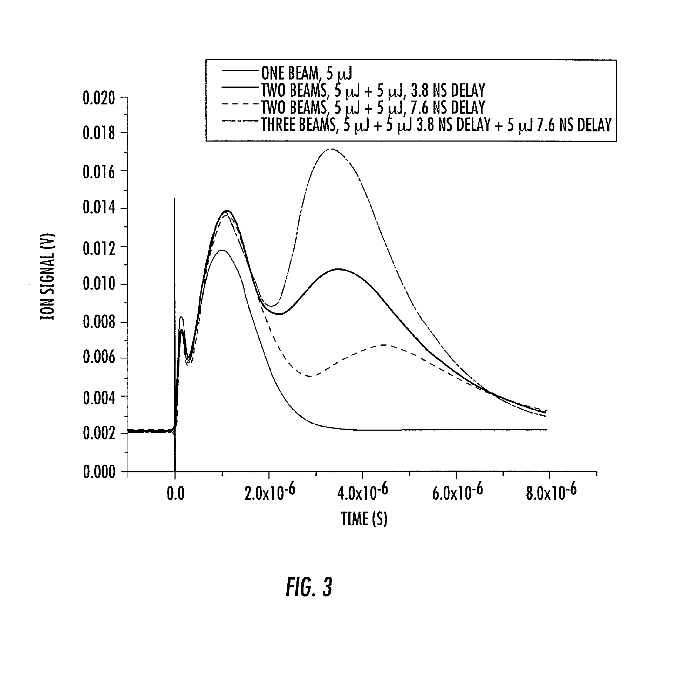

**FIGS. 3** **are** a set of time-resolved plume ion currents obtained with one-pulse, two-pulse, and three-pulse ablation of ZnO. The pulse energies are all 5 µJ. From bottom to top the four curves are ion currents of (i) single pulse ablation, (ii) double pulse ablation with a pulse separation of 7.6 ns, (iii) double pulse ablation with a pulse separation of 3.8 ns, and (iv) triple pulse ablation with a pulse separation of 3.8 ns. The ion current was measured with a Langmuir probe positioned in the laser plasma. The probe was placed 3 cm away from the target.

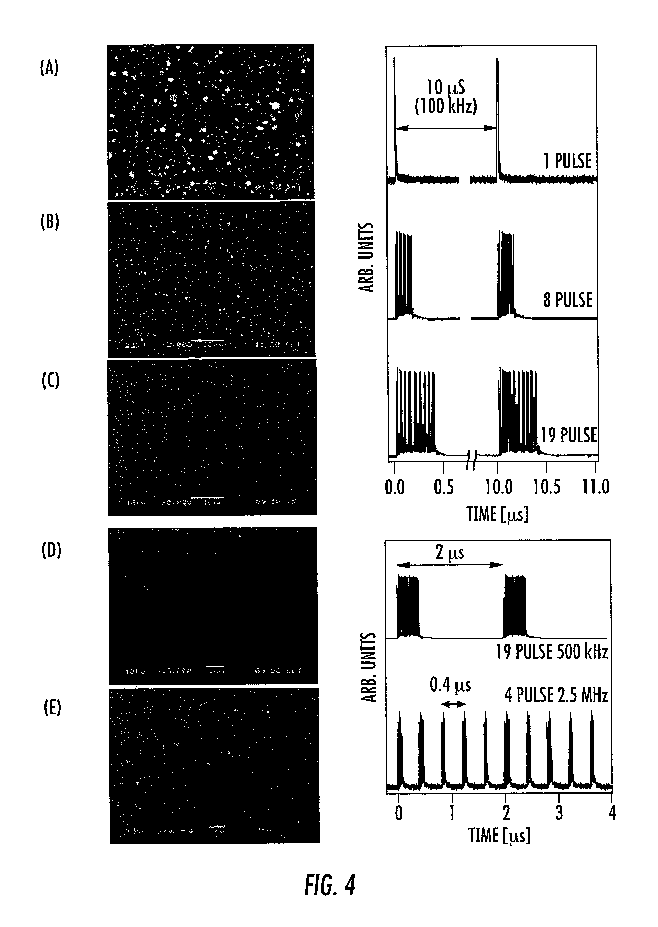

**FIGS. 4** illustrate SEM images of TiO₂ thin films fabricated by PLD using an ultrashort laser at the ambient oxygen pressure of 1x10⁻² mbar and the corresponding schematics of laser pulse profile. Laser parameters for the films in Fig. 4(a) were a single pulse at 200 kHz and 0.4 W; Fig 4(b), an 8-pulse burst at 200 kHz and 0.6 W; Fig 4(c), a 19-pulse burst at 500 kHz and 0.6W; Fig 4(d), a 19-pulse burst, 500 kHz and 0.6 W (high magnification); and Fig 4(e), a 4-pulse burst at 2.5 MHz and 0.6W. Magnifications of images are 2000x for Figs 4(a)-(c) and 10000x for Figs 4(d) and (e).

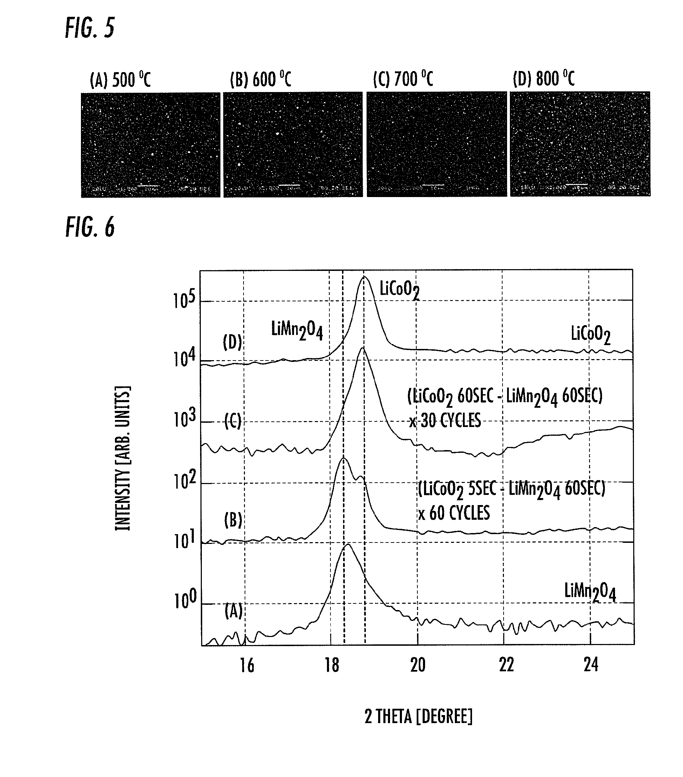

**FIG. 5** is a set of SEM images of LiMn₂O₄ thin films grown on a stainless steel substrate heated to (a) 500 °C; (b) 600 °C; (c) 700 °C; (d) 800 °C, during growth. It is apparent that the size of the nanoparticles does not depend on the substrate temperature.
**FIG. 6** shows a set of X-ray diffraction (XRD) results on (a)LiMn₂O₄, (b) 0.5 LiMn₂O₄ - 0.5 LiCoO₂, (c) 0.9 LiMn₂O₄ - 0.1 LiCoO₂ and (d) LiCoO₂ films grown on c-cut sapphire substrates.

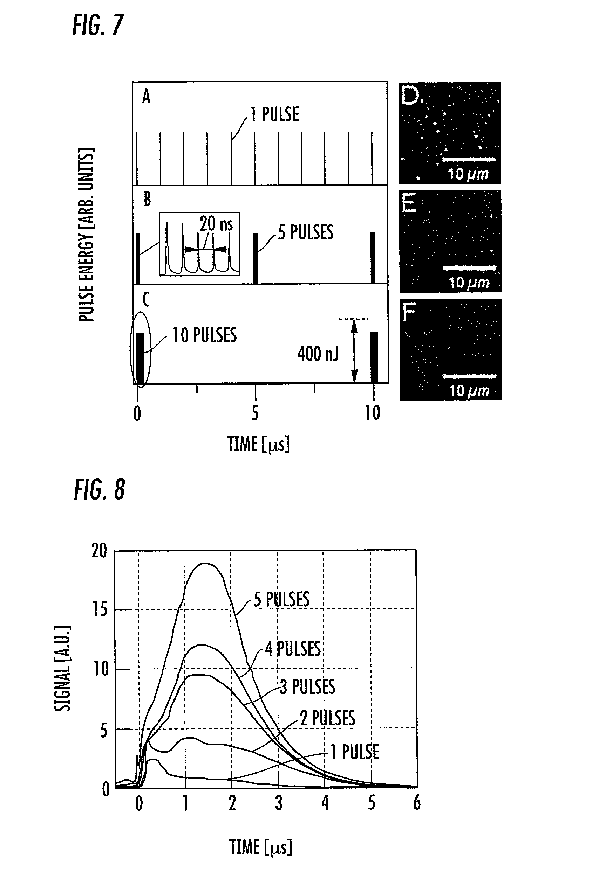

**FIGS. 7** illustrate another example of burst mode processing, wherein a TiO₂ sample is ablated with femtosecond pulses. The pulse sequences of three distinct burst-modes are schematically illustrated on the left portion of the figure (FIGS. A-C). Corresponding SEMs are shown the right (FIGS. D-F).
**FIG. 8** is a plot illustrating an example of time-resolved plume ion currents obtained with 1-5 pulse ablation of TiO₂. The pulse energies were all 3µJ. Ion current was measured with a Langmuir probe that was negatively biased (-50 V) and positioned 1 cm away from the target.

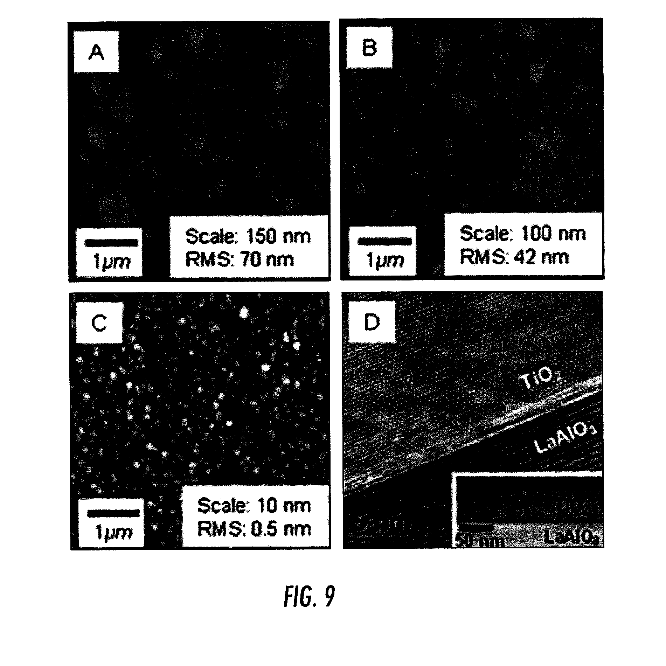

**FIGS. 9** illustrate atomic force microscope (AFM) images (A-C) of TiO₂ thin films ablated with varied laser parameters including the number of pulses in one burst, pulse energy, burst frequency, and laser power. The scale representing height (Z scale) and the root mean square (RMS) roughness measurements are shown in the inset of the AFM images. Also, (D) illustrates a cross sectional transmission electron microscope (TEM) image of epitaxial anatase type TiO₂ thin film grown on a LaAlO₃ (001) substrate at 1x10⁻⁴ mbar and 700 °C with specified laser parameters. The low magnification cross sectional TEM image is shown in the inset of (D).

### Detailed Description of the Invention

Embodiments of the present PLD invention generally utilize a burst of pulses for material synthesis to tune or otherwise control material morphology. For example, one or more laser pulses may be used to fabricate thin films so as to form distributions of nanoparticles with single ultrashort pulses. Additional pulses of a burst may be utilized to fabricate smooth, nearly particle free-films. Burst parameters, or parameters of pulses within a burst, may be based on known target emission characteristics. For example, a burst width of tens of nanoseconds, hundreds of nanoseconds, and up to several microseconds may be utilized in combination with pulses having a pulse width in a range of about 50 fs to about 100 ps. Generally a first pulse at least initiates a laser interaction with a target material, and at least a second pulse interacts with a by-product of the interaction. The interaction may be laser ablation and the by-product may include plume comprising charged and neutral particles.

Figure 1 schematically illustrates several elements of a pulsed laser deposition system, and an experimental arrangement used to carry out experiments disclosed herein. The system includes a vacuum chamber pumped by a turbo pump and a mechanical pump, a target manipulator which provides rotational and lateral movements for four targets of different materials, a substrate manipulator which provides heating and rotational and lateral movements for the substrate, a gas inlet through which reactive gases are provided and their pressures are appropriately adjusted, and an ion probe (Langmuir probe) to measure the ion current of the ablation plume, which can also be used as an indicator for adjusting the focusing of the laser beam on the target surface. When measuring the ion current, the ion probe is biased -10 V relative to the ground to collect the positive ions in the plume (the number of negative ions in the plasma is negligible).

FIGS. 1A-1B schematically illustrate examples of various laser systems suitable for ultrashort pulse laser deposition (PLD) systems, and particularly for operation in a burst mode.

FIG. 1A illustrates a fiber-based chirped pulse amplification system for producing ultrashort pulses. A commercially available laser capable of producing sub-picosecond pulses is the model FCPA µJewel D-1000 from IMRA America, Inc. A down counter (e.g.: "pulse picker") is used to reduce the repetition rate of the oscillator from about 50 MHz to a repetition rate in a range the hundreds of KHz to about 5 MHz. For example, if the oscillator rate is 50 MHz and pulses are selected at a rate of 1:50, the resulting output repetition rate is 1 MHz. The standard D-1000 configuration provides for a repetition rate between 100 KHz and 5 MHz, with a corresponding variation in pulse energy and pulse width. For example, pulse energy of about 10 µJ is specified for 100 KHz operation. For 5 MHz operation pulse energy of a few hundred nanojoules is available. Sub-picosecond pulses are generated, for example pulse widths in a range of about 700 fs to about 1 ps.

FIG. 1B illustrates an arrangement for decreasing the spacing between output pulses so as to produce a very high instantaneous repetition rate for a group of pulses. The delay-line configuration 101 utilizes polarization beam splitters 103 and an optical delay stage to generate a short burst of three pulses 105 , formed by splitting and combining a single input pulse 107, with a reduction in intensity as shown in Fig 1B. The spacing between the pulses is several nanoseconds and controlled by the length of optical path. The arrangement of FIG 1B was disposed at the output of regenerative amplifier provided by High Q Laser Production GmbHso as to carry out the experiments below. Such a delay line arrangement is suitable for producing a few pulses and is well known, but alignment and beam pointing stability are also factors to consider in various PLD applications where precise positioning of a laser spot may be required.

In some embodiments, low dispersion optical components may be utilized to optimize the quality of the femtosecond pulses. Optical components for such dispersion control are available, for example components in the FemtoOptics product family provided by Femtolasers Produktions, GmbH.

In various embodiments burst mode operation may be achieved through an Acousto-Optic Modulator (AOM) that is used for pulse selection and intensity control in a chirped pulse amplification (CPA) system. Referring to FIG. 1C, an AOM or other suitable optical switch is disposed to receive pulses the oscillator, and may be disposed before a pre-amplifier (e.g.: as in FIG 1A) and power-amplifier, and controlled to select multiple oscillator pulses for amplification. The number of pulses in each burst is determined by the AOM gate width, i.e., the time duration in which the switch is open. For example, a typical oscillator generates pulses with a high repetition rate of 50 MHz, i.e., with a pulse interval of 20 ns. Therefore, if the AOM gate opens each time for 100 ns, the output burst mode will have 5 pulses in each burst, and the burst repetition rate is determined by the AOM repetition rate.

An embodiment of a "burst mode" PLD system may include a user interface providing access to the controller of FIG. 1A. The AOM (or other suitable switch) is programmed so that the number of pulses, pulse spacing, intensity, and burst intensity profile (e.g.: the envelope defined by the pulses of the burst) are adjustable over a reasonable range, for example about 10:1.By way of example, in carrying out some experiments below a standard model D-1000 was modified to provide a user interface for selection of multiple pulses, so as to produce ultrashort outputs. FIG. 2 illustrates an example of a burst of laser pulses. For example, experiments with bursts of 8 and 19 pulses, with temporal spacing of 20 ns. The selected groups of pulses were stretched to several hundred picoseconds, amplified with a fiber power amplifier, and then compressed to sub-picosecond pulses at the output of the compressor, as shown in FIGS 1A and 1C.

In various embodiments numerous laser parameters may be adjusted, pre-set, or otherwise controlled to further refine the distributions of particles and/or provide for approximately particle free films. For example, in various embodiments one or more of the following parameters may affect at least one physical property of a film and be used to control film morphology: the output energy of a pulse or group of pulses within a burst, a spacing between pulses, the number of pulses, a pulse width, an intensity profile of the burst, and the power density at the surface of a target (by adjustment of replacement of optical components (e.g: the lens in Fig 1). Various wavelengths in the range of about .2 µm to about 2 µm may be utilized.

Numerous laser configurations may be utilized to carry out burst mode PLD. Fiber laser and amplifier technology provides numerous benefits for burst mode operation. Other configurations are possible.

U.S. Patent 7,113,327 to Gu entitled "High Power Chirped Pulse Amplification System Using Telecom-Type Components" and U.S. Patent Application Ser. No. 10/437,057 to Harter entitled "Inexpensive Variable Rep-Rate Source for High Energy Ultra-fast Lasers" are hereby both incorporated by reference in their entirety. The '327 patent discloses the use of an GHZ modulator, for example a Mach-Zehnder or electro-absorption modulator, useable for very high speed pulse selection at near IR wavelengths. Various embodiments disclosed in 10/437,057 disclose non-mode locked sources for generating ultrashort pulses at repetition rates in the range up to about 10 MHz or greater.

Commercially available ultrashort source and systems may be utilized in some embodiments. Burst mode operation wherein at least two pulses are delivered to a target during an interval from about 1 ns to 1 µs may be carried out using CW mode locked lasers, q-switched and mode locked lasers, high speed semiconductor diodes and modulators, and combinations thereof. Optical amplifiers, for example fiber amplifiers or bulk amplifiers, may be utilized to increase the pulse energy from the source with some tradeoff in the achievable repetition rate. High speed modulators may be utilized to select pulses, control the intensity of pulses, and vary the effective repetition rate. In some embodiments wavelength converters may be utilized to increase or decrease the laser wavelength.

In a preferred embodiment, an ultrashort laser is positioned outside the chamber and the laser beam is focused onto the target surface through a fused silica window. A shutter is placed before the focusing lens, which is controlled by a computer program. The laser shutter can be synchronized with lateral movements of the four targets to switch between different materials.

In some embodiments laser pulse width may be in a range of about 10 fs to about 50 ps (up to about 100ps), and preferably between 10 fs-1ps. In some embodiments, at least one pulse width may be less than 1 ns, and more preferably less than 500 ps, depending on material interaction requirements. An exemplary pulse energy may be in the range of about 10 nJ to 100 µJ, 50nJ-100 µJ, or within similar ranges, and may typically be in the range of 50 nJ to 10 µJ. For example, a pulse energy may be in the range of about 1 nJ to 500 µJ and provide for sufficient fluence to ablate target material. Generally, less total energy is required to obtain a pre-determined fluence within a smaller focused spot area. In various embodiments a focused spot diameter may be in the range of about 10 µm to 40 µm, for example in the range of about 20 µm to 30 µm. In some embodiments, PLD may be carried out by selecting and amplifying pulses from the oscillator (e.g.: 10 ps pulses), or amplifying stretched oscillator pulses (e.g: 100 ps, 200 ps, 500 ps), so as to produce amplified and non-compressed picosecond output pulses.Many possibilities exist.

The PLD system also includes optical elements for delivering the laser beam such that the beam is focused onto the target surface with an appropriate average energy density and an appropriate energy density distribution.

Materials used for testing include metal Ni and Co, metal oxides TiO₂ (single crystal and sintered powder targets), ZnO, LiMnO₂, LiMn₂O₄ and LiCoO₂, and the last four materials are provided as compressed powder (ceramics) targets. In this example the targets were sintered but the packing density was as low as about 50%. It is not essential that the packing density of the target be high. For example, the packing density may be as low as 50% of its theoretical density. By way of example, LiMnO₂ nanoparticle and particle free films were grown by ablating low density targets (as low as 40% of theoretical density). Other materials may include LiCoO₂ and metal oxides, such as LiNiO₂, LiTiO₂, LiVO₂, or any suitable composition obtainable using burst mode processing. Generally, a wide range of materials are useable with embodiments of the present disclosure, for example: metals, semiconductors, metal oxides, metal nitrides, fluorides, arsenides, sulfides, and organic materials. The application of the current invention is not limited to the above-listed demonstration materials. For example, burst-mode PLD may be carried out with target materials representative of species within each of the noted generic classes of materials.

Figure 3 shows a few examples of transient ion current collected with different numbers of pulses during ablation of ZnO. The pulse energy used here is 5 µJ. From bottom to top the four curves are ion currents of (i) single pulse ablation, (ii) double pulse ablation with a pulse separation of 7.6 ns, (iii) double pulse ablation with a pulse separation of 3.8 ns, and (iv) triple pulse ablation with a pulse separation of 3.8 ns. It is observed that for short time separations between adjacent pulses, the plume ion signal generated by the first pulse is increased by the second (and subsequent) pulses, which shows up as additional peaks in the transient ion current. For example, in the case of the double pulse ablation with a pulse separation of 7.6 ns (the second curve from the bottom), the second pulse generates an additional peak in the ion current, which appears at 4.5 µs after the detector sees the first ion pulse (i.e., the first peak) at 1 µs. This long time difference between first and the second ion peaks indicates that the second laser pulse hits (and is absorbed by) the tail of the plume generated by the first laser pulse, instead of hitting the target. We have demonstrated that this 'catch-up' effect between the leading plume and the subsequent laser pulses with a pulse separation of up to 25 nanoseconds (corresponding to a base repetition rate of 40 MHz). The top curve in Figure 3 shows a significant build-up of ion signal with three pulses. This build-up of ions can be interpreted as (accumulative) ionization of the neutral species in the leading plume by consecutive laser pulses.

We note that the slow flying of the neutral species (as indicated by the large time difference between the ion signal peaks) can be due to (i) slow thermal evaporation and (ii) large mass of the neutral species, which can be in the form of clusters (e.g., dimers, trimers, etc.) and nanoparticles. Therefore the "catching-up" between the leading plume and the following laser pulses will have two effects. First, when the charge density in the leading plume builds up sufficiently highly, the plume will block the subsequent laser pulses by plasma absorption (shielding). Second, when the plasma shielding starts to occur, the clusters and nanoparticles contained in the plume will be ablated by the incoming laser pulses. With a sufficient number of pulses in the bursts, the clusters and nanoparticles will eventually break down to gaseous form. A few examples are given below.

### Example of size control of nanoparticles

Figure 4 shows several SEM images of TiO₂ thin films fabricated by PLD using an ultrashort laser at an ambient oxygen pressure (1x10⁻² mbar) and corresponding schematics of the laser pulse profile. As clearly shown in Fig 4(a) - 4(c), the size of particles in the film decreases as the number of pulses in a laser burst increases. It is difficult to find particles in the film deposited with the 19-pulse burst mode PLD at high magnification, as particularly illustrated in FIGS. 4(c) and (d). A dust particle disposed at the surface, not a product of the PLD process, is the only structure visible in the SEM image. This surprising result further suggests that burst mode operation can be used to tune the morphology over a wide range: for example for production of detectable nanoparticles having a pre-determined physical property to formation of thin films substantially free of particles. In the latter case, various embodiments of the present invention provide a mechanism for in-situ vapor deposition of a substrate, i.e., where the vapor is formed by particulate breakdown conducted literally "on the fly".

The same trends have been observed with metals (Ni and Co), semiconductors (ZnO), and other metal oxides (LiMn₂O₄ and LiMnO₂). From these facts, we deduce that the effect is independent of target material, and would apply, for example, to organic materials. Figure 4(d) and 4(c) are SEM images of different magnification for the film deposited with the 19-pulse burst mode PLD where the laser delivered 9.5x10⁶ pulses per second, each pulse having 63nJ of energy. As a comparison, we deposited a film under the same conditions as the film in Fig. 4(d), with 0.6W of laser power, 1x10⁻² mbar of oxygen pressure and 60 minutes of deposition time and roughly same delivery rate of laser pulses (10x10⁶ per second) and laser energy (60nJ per pulse), but we regrouped the laser pulses in 4-pulse bursts with a burst repetition rate of 2.5 MHz. Fig. 4(e) shows the SEM image of this film. From this comparison we strongly believe that the initial several low energy laser pulses generate particles from laser ablation, and that these particles are broken down with the subsequent low energy laser pulses, therefore we are able to deposit films with very smooth surfaces. It also suggests that 'burst' laser ablation is more efficient than continuous pulsed laser ablation in breaking down the particle size.

Figure 5 shows a set of SEM images of LiMn₂O₄ thin films grown on stainless steel substrates at different substrate temperature during growth. Ambient oxygen pressure (1x10⁻² mbar) and laser parameters (number of burst pulses: 8-pulses, laser repetition rate: 200 kHz, laser fluence: 0.64 W) were the same for these depositions. It is clearly observed that size of the particles in the films grown at different temperature is quite similar. This suggests that size control of nanoparticles is strongly affected by laser parameters for target ablation, not the substrate temperature, during the growth.

### Example of size controlled nanocomposite

Figures 6(a)-(d) are selected X-ray diffraction (XRD) θ-2θ patterns of LiMn₂O₄, LiCoO₂ and their composite films (deposition time ratios of LiMn₂O₄ and LiCoO₂ are 1:1 and 12:1 respectively in Figs 6(b) and 6(c)) deposited on a c-cut sapphire single crystal substrate. The deposition ratio for each of the materials was controlled by the deposition time of each target. The growth temperature of the substrate is 600°C. Laser parameters, e.g., number of burst pulses, laser fluence, and laser repetition rate are 8 pulses, 0.4uJ (0.64 W), and 200 kHz. Processing oxygen gas pressure during depositions was 1x10⁻² mbar. The data were obtained using a Rigaku MiniFlex X-Ray Diffractometer. Crystalline LiMn₂O₄ and LiCoO₂ films (nanoparticles) are epitaxially grown on c-cut Al₂O₃ substrates as shown in Figs. 6 (a) and (d). Both LiMn₂O₄ and LiCoO₂ crystalline phases are observed in the mixture of LiMn₂O₄ and LiCoO₂ thin films as shown in Figs 6(b) and (c). It is indicated that the materials are phase-separated composites, not solid-solution.

It was also confirmed that the size of nanoparticles can be independently controlled. Referring again to Figure 4, the effect of burst processing is evident, and is applicable for PLD of metal oxides, and may be applicable for many other materials, for example organic materials. The results show LiCoO₂ and LiMn₂O₄ and the ratio of LiMn₂O₄ and LiCoO₂ phases can be independently controlled. The deposition time may further control the size and ratio of the particles. In some embodiments deposited particles may be sufficiently small so as to diffuse and create a solid solution.

### Additional examples, embodiments, and discussion

Using a burst of pulses, most preferably femtosecond pulses, provides for control of particle size. FIG. 7(D)-(F) are additional SEM images of TiO₂ films deposited using the exemplary burst parameters illustrated in FIG.7 (A)-(C). In the three illustrations , the number of burst-mode pulses is 1, 5, and 10 from (A) to (C), respectively. The burst repetition rate is varied to keep the same total number of laser shots (per second) and the same total average power (0.4W). The pulse energy is 0.4 µJ in all three cases. The depositions were performed at room temperature in oxygen of 1x10⁻² mbar.

By increasing the number of pulses in each burst, the average particle-size of the films becomes smaller. In the example of FIG. 7D, bursts having ten pulses with separation of about 10 µs between the groups of pulses produced a film effectively free of particles (a similar result is also shown in FIG. 4D).

The deposition rate also increases with the number of pulses in the burst. The observed deposition rates are 0.05, 0.25, and 0.33 Å/s for the pulse sequences shown in FIG. 7 (A)-(C), respectively.

The film morphology and deposition rate are thus controllable as a function of the pulse energy and the repetition rate. In this example, the pulse energy incident on the target is the same. Without subscribing to any particular theory, it appears this interesting phenomenon is related to the *catching up* effects that occur both on the target surface and in the plume, as further discussed below.

FIG. 8 is a plot illustrating an example of time-resolved plume ion currents obtained with 1-5 pulse ablation of TiO₂. Ablation plume plasma was studied using a Langmuir probe, which is a simple and effective way to study the electric properties of plasmas. The plot is similar to that of FIG. 3, which illustrated results obtained with processing of ZnO, but with different burst parameters. Referring to FIG. 8, the ablated material is TiO₂, and up to 5 pulses were used. Also, the pulse delay time was increased to 20 ns from 3.8 ns and 7.6 ns, and pulse energy was reduced to 3 uJ from 5 uJ. A transient ion signal as a function of the time was recorded by inserting a negatively biased (-50 V) 2 x 2 mm sized metal plate in the plume which was placed 1 cm away from the target. Referring to FIG. 8, the number of pulses in the burst, from the bottom to the top curves, was varied from 1 to 5, respectively, and the temporal separation between the pulses was 20 ns. Sufficient signal strength was obtained with 3 µJ pulse energy. With the single pulse ablation (the bottom curve), the transient ion signal contains a fast peak at 0.2 µs and a slow tail extending to several microseconds, indicating a plume with a fast and ionized crest-like front and a slow moving body. The fast ionized front is characteristic for ultrashort pulsed laser ablation, as a result of non-thermal ablation effects such as surface Coulumb explosion. According to several reports of spatially resolved optical emission spectra, the slow moving body of ultrashort ablation plume contains mostly neutral species. For example, such observations are reported in "Molecular-dynamics study of ablation of solids under femtosecond laser pulses" D. Perez and L. J. Lewis, Phys. Rev. B 67, 184102 (2003), "Femtosecond laser ablation of nickel in vacuum" S. Amoruso, R. Bruzzese, X. Wang, N. N. Nedialkov and P. A. Atanasov, J. Phys. D 40, 331 (2007), and "Propagation of a femtosecond pulsed laser ablation plume into a background atmosphere" S. Amoruso, R. Bruzzese, X. Wang, and J. Xia, Appl. Phys. Lett. 92, 041503 (2008)

With burst mode ablation, it appears the slow moving tail became significantly ionized while the intensity of the fast ionized front remained unchanged. For example, when a rapid sequence of at least three pulses is applied, the signal is effectively dominated by the slow moving ions. These observations can be interpreted as results of memory effects in the plume, i.e., before expanding to negligible density, the plume produced by the leading pulse is repeatedly hit by the subsequent pulses. The significant enhancement of ionization of the plume body during multiple-pulse ablation suggests that before reaching to the target surface, the late-coming pulses can be strongly interacted (absorbed) by the plume produced by the early pulses due to the short pulse separation and the slow movement of the plume body.

The gradual decrease in of the particle-size with increasing number of pulses in the bursts as shown in FIG. 7 may be related to the plume-pulse interaction in several ways. Although it is not necessary to the practice of embodiments of the disclosed burst PLD systems and methods to understand the operative mechanism therein, and without subscribing to any particular theory, a possible mechanism is evaporation of the particles during the burst-mode laser ablations. In a molecular dynamic (MD) simulation study of plume expansion and particle population evolution in the plume for the single pulse ablation, it has been found that small particles will undergo a growth/evaporation process, depending on the ambient conditions (e.g., pressure) even within the short time scale of plume expansion (less than 1 µs). In our experiments, it is possible that the particles generated by the first few pulses can be evaporated because of the repeated heating effects on the plume by the subsequent pulses. Another possibility is that small charged particles can be unstable against splitting because of the large Coulumbic part of free energy.

The increasing deposition rate (which relates to increasing material removal rate) with greater numbers of pulses in each burst (but same average power) is interesting. Incubation effects caused by repeated ablation (i.e., reduced ablation threshold due to previously damaged surfaces) does not provide for an explanation because the total number laser shots the target receives is the same with the different pulse sequences of the example in FIG. 7. We currently attribute this to (i) surface heat accumulation and (ii) plasma re-sputtering, Both phenomena can result in increased material removal rate, although the exact mechanism is not yet fully understood.

As examples showing further control of particle size, FIGS. 9(A) - (C) show AFM (atomic force microscope) images of TiO₂ films prepared using different burst-mode conditions:

FIG 9A: Single pulse, 5µJ pulse energy, 200 KHz rep rate, 1W avg. power,

FIG 9B: 10 pulses, 0.5µJ pulse energy, 200 KHz rep rate, 1W avg. power,

FIG 9C: 19 pulses, 0.05µJ pulse energy, 1 MHz rep rate, 0.95 W avg. power,

The AFM results are representative of the SEMs results shown in FIGS. 4 (a)-(c) of the patent, but with different samples used for processing.

It follows from the exemplary micrographs of FIGS. 2 and 7, and the corresponding pulse parameters, that the particle-size can be well controlled from sub-micrometer down to an approximate *particle free* limit. The film morphology can be controlled by controlling burst-mode laser parameters. Note that smaller particle-size or smoother surface films can be obtained by increasing the number of pulses and/or decreasing pulse energy. Also, when TiO₂ target material is ablated with high pulse energy, the ablated material is crystallized, even if grown at room temperature. Therefore, as an additional benefit, the film can have photocatalytic activities even at room temperature growth.

Additional information regarding processes for depositing films of crystalline TiO₂ onto a substrate surface with the use of picosecond or femtosecond pulses is disclosed in Appl. No. 11/798,114, entitled "Method for Depositing Crystalline Titania Nanoparticles and Films", filed May 10, 2007, now published as U.S. Patent Application Pub. No. 2008/0187864, and incorporated by reference herein.

Now referring to FIG. 9D, the satisfactory film morphology and quality obtainable with the use of burst-mode ablation are further demonstrated. A TiO₂ thin film was grown with a 19 pulse-burst on a LaAlO₃ (001) substrate at 700 °C in an oxygen pressure of 1x10⁻⁴ mbar. Other laser parameters included: burst repetition rate -1 MHz; laser power - 0.95 W, pulse energy - 0.05 µJ. A cross section of a high-resolution transmission electron microscope (TEM) image and low magnification images of the film are shown in FIG. 9D and the inset, respectively. These results reveal that high-quality anatase type TiO₂ films may be epitaxially grown with an atomically smooth interface between the film and substrate, and smooth film surface. The full-width half-maximum of rocking curve of the (004) anatase peak using XRD (not shown) shows 0.11 degree, which is about same quality as that grown by PLD using a nanosecond KrF excimer laser reported in "Anatase TiO2 thin films grown on lattice-matched LaAlO3 substrate by laser molecular-beam epitaxy" M. Murakami, Y. Matsumoto, and K. Nakjima, T. Makino and Y. Segawa, T. Chikyow and P. Ahmet, M. Kawasaki, H. Koinuma: Appl. Phys. Lett. 78 18 2664-2666 (2001).

Moreover, the root mean square of 70 nm TiO₂ thin films obtained by AFM with a 3 x 3 *um²* scan is < 0.22 nm, which is even better than that of many other thin film deposition techniques. No droplets or micro-meter size clusters can be found in sub-millimeter scale by optical microscope images. The result revealed that burst-mode femtosecond PLD is also an excellent technique for growing high quality thin films.

The control of particle-size is extendable to many other materials such as metals, metal oxides, and semiconductors. An example of a transparent metal is reported in: "A transparent metal: Nb-doped anatase TiO2", Y. Furubayashi, T. Hitosugi, Y. Yamamoto, K. Inaba, G. Kinoda, Y. Hirose, T. Shimada, and T. Hasegawa; Appl. Phys. Lett. 86, 252101 (2005). In at least one embodiment utilizing burst-mode PLD, resistivity of such a transparent electrode having Nb doped TiO₂ can be controlled over more than 4 orders of magnitude by only changing laser parameters for growth. Further, the magnetic properties of magnetic metals (Co and Ni_{0.2}Fe_{0.8}) can be tuned by controlling their particle-size.

Burst-mode PLD using ultrashort pulses, for example pulses having widths below 100 ps, or about 10 ps or shorter, and most preferably femtosecond pulses, provide for the control of both film morphology and particle-size. Pulses may be applied at pulse separations of about 1 ns to several hundred nanoseconds, corresponding to pulse repetition rates (e.g.: instantaneous repetition rate) of at least 1 MHz up to about 1 GHz. Several laser configurations are possible depending upon desired pulse parameters, for example pulse energy, pulse width, and average power. Such burst mode technology may be suitable for numerous applications to nanotechnology and nanofabrication.

In some embodiments adjustment or selection of laser parameters produce smooth thin-films which may comprise super-lattice or multilayer structures. Previously nanosecond PLD and other thin-film deposition methods were utilized to produce solid solution, multilayer, and super-lattice structures. However, such systems do not provide capability for controlling film morphology so as to optionally create either nanoparticles or smooth, nearly scatter free thin films as demonstrated herein, wherein pulse characteristics of a burst of ultrashort pulses tune or otherwise affect the morphology. Moreover, nanosecond systems are limited for size control and droplets resulting from melting are difficult to avoid. Other techniques, for example sputtering and e-beam high melting point materials.

In various embodiments thin-film materials produced using a burst of pulses may include: metals, alloys, metal oxides, metal nitrides, metal fluorides, metal arsenides, metal sulfides, semiconductors, carbons, glass, polymers, and composite materials. Other thin film materials may be produced.

Thin-film materials may have a microstructure of amorphous or crystalline phase, or a mixture of both amorphous and crystalline phases.

Thin-film materials may include solid solutions or nanocomposites or superlattice structures of multimaterials by alternately or simultaneously ablating different target materials.

Thus, while only certain embodiments have been specifically described herein, it will be apparent that numerous modifications may be made thereto without departing from the scope of the invention. Further, acronyms are used merely to enhance the readability of the specification and claims. It should be noted that these acronyms are not intended to lessen the generality of the terms used and they should not be construed to restrict the scope of the claims to the embodiments described therein.

## Claims

1. A method of pulsed laser deposition for material synthesis on a substrate material, said method comprising:
directing a burst of laser pulses having pulse widths of less than 1 ns toward an interaction region to cause an initial laser interaction between a target and at least one pulse of the burst, and also to cause at least one further laser interaction between an emission caused by said initial interaction and at least one subsequent pulse of said burst, said at least one further interaction modifying said emission caused by said initial interaction so as to synthesize a thin film on said substrate and to control a property of said thin-film material, including an average size and number of particles on or within the synthesized material,
wherein the average size of particles on or within said synthesized material decreases with an increasing number of pulses within said burst over a burst duration less than several microseconds,
said burst providing for continuous tuning of a morphology of said synthesized material with control of burst parameters,
wherein said at least one subsequent pulse of said burst also ablates said target,
wherein multiple bursts having said parameters and said duration less than several microseconds are generated at varied burst repetition rates in such a way that a rate of laser pulses per second and average laser power remain constant during said pulsed laser deposition of said thin-film material onto said substrate, and
wherein the number of pulses in each burst and the repetition rate of the burst are controlled independently.

2. The method of claim 1, wherein said emission comprises a plume of particles from said target.

3. The method of claim 1, wherein said property comprises at least one of a number, size and distribution of particles deposited on said film, said property being affected by controlling at least one of a pulse characteristic and burst characteristic.

4. The method of claim 1, wherein at least one of a pulse energy and number of pulses within said burst are controlled in such a way that limits the number of particles on or within said thin-film material so as to produce a substantially particle-free thin film.

5. The method of claim 1, wherein said burst comprises at least two pulses having at least one of a different temporal spacing, a different energy, a different pulse width, and a different peak power.

6. The method of claim 1, wherein said emission caused by said initial interaction comprises ablation plume produced by at least one pulse of the burst, wherein said ablation plume interacts with one or more subsequent pulses of said burst during said further interaction.

7. The method of claim 1, wherein said laser pulses comprise a pulse duration less than about than 500 ps.

8. The method of claim 1, wherein each burst comprises 2-200 pulses.

9. The method of claim 1, wherein the pulses in the burst have wavelengths in the near infrared spectral range.

10. The method of claim 1, wherein a selected pulse separation between individual pulses is less than about 1 µs.

11. The method of claim 1, further comprising monitoring plasma ion current during laser ablation/deposition.

12. The method of claim 1, wherein the thin-film materials comprise nanoparticle aggregates, nanoparticle-embedded nanocomposite films, and particle-free and droplet-free smooth film.

13. The method of claim 1 comprising: selecting a thin-film morphology by selecting a burst parameter.

14. The method of claim 1, wherein the said thin-film materials comprise at least one material selected from a metal, alloy, metal oxide, metal nitride, metal fluoride, metal arsenide, metal sulfide, semiconductor, carbon, glass, polymer, and composite material.

15. The method of claim 1, wherein said thin-film materials comprise a microstructure of amorphous or crystalline phase, or a mixture of both amorphous and crystalline phases.

16. The method of claim 1, wherein said thin-film materials include solid solutions or nanocomposites or superlattice structures of multimaterials formed by alternately or simultaneously ablating different target materials.

17. The method of claim 1, wherein the burst is generated, at least in part, with an acousto optic modulator (AOM) that is used for pulse selection in a chirped pulse amplification (CPA) system, and the burst width and burst repetition rate are determined by a gate width and repetition rate of the AOM, respectively.

## Patentansprüche

1. Verfahren zur gepulsten Laserabscheidung für die Materialsynthese auf einem Substratmaterial, wobei das Verfahren umfasst:
Lenken eines Bündels von Laserimpulsen mit Imulsbreiten von weniger als 1 ns auf einen Wechselwirkungsbereich, um eine Anfangs-Laserwechselwirkung zwischen einem Ziel und wenigstens einem Impuls des Bündels zu bewirken, und auch, um wenigstens eine weitere Laser-Wechselwirkung zwischen einer von der Anfangs-Wechselwirkung verursachten Emission und wenigstens einem nachfolgenden Impuls des Bündels zu bewirken, wobei die wenigstens eine weitere Wechselwirkung die von der Anfangs-Wechselwirkung verursachte Emission modifiziert, um einen Dünnfilm auf dem Substrat zu synthetisieren und eine Eigenschaft des Dünnfilmmaterials zu steuern, einschließlich der mittleren Größe und der Anzahl von Partikeln auf oder in dem synthetisierten Material,
wobei die mittlere Größe von Partikeln auf oder in dem synthetisierten Material mit zunehmender Anzahl von Impulsen in dem Bündel über eine Bündeldauer von weniger als mehreren Mikrosekunden abnimmt,
wobei das Bündel von Impulsen ein kontinuierliches Einstellen einer Morphologie des synthetisierten Materials über ein Steuern von Parametern des Bündels ermöglicht,
wobei der wenigstens eine nachfolgende Impuls des Bündels ebenfalls das Ziel abträgt,
wobei mehrere Bündel mit den Parametern und der Dauer von weniger als mehreren Mikrosekunden mit unterschiedlichen Bündel-Wiederholungsraten so erzeugt werden, dass die Rate von Laserimpulsen pro Sekunde und die mittlere Laserleistung während der gepulsten Laserabscheidung des Dünnfilmmaterials auf das Substrat konstant bleiben, und
wobei die Anzahl von Impulsen in jedem Bündel und die Wiederholungsrate der Bündel unabhängig gesteuert werden.

2. Verfahren gemäß Anspruch 1, wobei die Emission eine Schwade von Partikeln aus dem Ziel umfasst.

3. Verfahren gemäß Anspruch 1, wobei die Eigenschaft wenigstens eines von Anzahl, Größe und Verteilung von auf dem Film abgeschiedenen Partikeln umfasst, wobei die Eigenschaft durch Steuern von wenigstens einem von einem Impulsmerkmal und einem Bündelmerkmal beeinflusst wird.

4. Verfahren gemäß Anspruch 1, wobei wenigstens eine Impulsenergie oder eine Anzahl von Impulsen in dem Bündel so gesteuert wird, dass die Anzahl von Partikeln auf oder in dem Dünnfilmmaterial beschränkt wird, um einen im Wesentlichen partikelfreien Dünnfilm zu erzeugen.

5. Verfahren gemäß Anspruch 1, wobei das Bündel wenigstens zwei Impulse umfasst, die wenigstens eines von einem unterschiedlichen zeitlichen Abstand, einer unterschiedlichen Energie, einer unterschiedlichen Impulsbreite und einer unterschiedlichen Spitzenleistung aufweisen.

6. Verfahren gemäß Anspruch 1, wobei die von der Anfangswechselwirkung bewirkte Emission Ablationsschwaden umfasst, die von wenigstens einem Impuls des Bündels verursacht werden, wobei die Ablationsschwaden mit einem oder mehreren nachfolgenden Impulsen des Bündels während der weiteren Wechselwirkung wechselwirken.

7. Verfahren gemäß Anspruch 1, wobei die Laserimpulse eine Impulsdauer von weniger als etwa 500 ps umfassen.

8. Verfahren gemäß Anspruch 1, wobei jedes Bündel 2 bis 200 Impulse umfasst.

9. Verfahren gemäß Anspruch 1, wobei die Impulse in dem Bündel Wellenlängen im Nahinfrarot-Spektralbereich aufweisen.

10. Verfahren gemäß Anspruch 1, wobei eine ausgewählte Impulspause zwischen einzelnen Impulsen weniger als etwa 1 µs beträgt.

11. Verfahren gemäß Anspruch 1, ferner umfassend Überwachen des Plasma-Ionenstroms während der Laserablation/abscheidung.

12. Verfahren gemäß Anspruch 1, wobei die Dünnfilmmaterialien Nanopartikelaggregate, Nanopartikel eingebettet in Nanokompositfilme und partikelfreien und tröpchenfreien glatten Film umfassen.

13. Verfahren gemäß Anspruch 1, umfassend: Auswählen einer Dünnfilm-Morphologie durch Auswählen eines Bündelparameters.

14. Verfahren gemäß Anspruch 1, wobei die Dünnfilmmaterialien wenigstens ein Material ausgewählt aus einem Metall, einer Legierung, einem Metalloxid, einem Metallnitrid, einem Metallfluorid, einem Metallarsenid, einem Metallsulfid, einem Halbleiter, Kohlenstoff, einem Glas, einem Polymer und einem Kompositmaterial umfassen.

15. Verfahren gemäß Anspruch 1, wobei die Dünnfilmmaterialien eine Mikrostruktur mit amorpher oder kristalliner Phase oder ein Gemisch von sowohl amorphen als auch kristallinen Phasen umfassen.

16. Verfahren gemäß Anspruch 1, wobei die Dünnfilmmaterialien feste Lösungen oder Nanokomposite oder Supergitterstrukturen von Multimaterialien umfassen, die durch abwechselnde oder gleichzeitige Ablation verschiedener Zielmaterialien gebildet werden.

17. Verfahren gemäß Anspruch 1, wobei das Bündel zumindest zum Teil mit einem akusto-optischen Modulator (AOM) erzeugt wird, der für die Impulsselektion in einem Chirped-Pulse-Amplification-System (CPA) verwendet wird, und die Bündeldauer und Bündel-Wiederholungsrate durch die Gatebreite bzw. die Wiederholungsrate des AOM bestimmt werden.

## Revendications

1. Procédé de dépôt par laser pulsé pour la synthèse de matériaux sur un matériau substrat, ledit procédé comprenant :
l'orientation d'une salve d'impulsions laser ayant des largeurs d'impulsion de moins de 1 ns vers une région d'interaction pour provoquer une interaction laser initiale entre une cible et au moins une impulsion de la salve, et pour provoquer également au moins une autre interaction laser entre une émission provoquée par ladite interaction initiale et au moins une impulsion consécutive de ladite salve, ladite au moins une autre interaction modifiant ladite émission provoquée par ladite interaction initiale de manière à synthétiser un film mince sur ledit substrat et à contrôler une propriété dudit matériau en film mince, notamment une taille moyenne et un nombre de particules sur ou à l'intérieur du matériau synthétisé,
dans lequel la taille moyenne de particules sur ou à l'intérieur dudit matériau synthétisé diminue avec un nombre croissant d'impulsions à l'intérieur de ladite salve sur une durée de salve inférieure à plusieurs microsecondes,
ladite salve assurant un ajustement continu d'une morphologie dudit matériau synthétisé par contrôle de paramètres de salve,
dans lequel ladite au moins une impulsion consécutive de ladite salve décape également ladite cible,
dans lequel de multiples salves ayant lesdits paramètres et ladite durée inférieure à plusieurs microsecondes sont générées à des cadences de répétition de salve variées de telle sorte qu'une cadence d'impulsion laser par seconde et une puissance laser moyenne restent constantes pendant ledit dépôt par laser pulsé dudit matériau en film mince sur ledit substrat, et
dans lequel le nombre d'impulsions dans chaque salve et la cadence de répétition de la salve sont contrôlés indépendamment.

2. Procédé selon la revendication 1, dans lequel ladite émission comprend un panache de particules provenant de ladite cible.

3. Procédé selon la revendication 1, dans lequel ladite propriété comprend un nombre, et/ou une taille, et/ou une distribution de particules déposées sur ledit film, ladite propriété étant affectée en contrôlant une caractéristique d'impulsion et/ou une caractéristique de salve.

4. Procédé selon la revendication 1, dans lequel l'énergie d'impulsion et/ou le nombre d'impulsions à l'intérieur de ladite salve sont contrôlés d'une manière qui limite le nombre de particules sur ou à l'intérieur dudit matériau en film mince de manière à produire un film mince sensiblement sans particules.

5. Procédé selon la revendication 1, dans lequel ladite salve comprend au moins deux impulsions ayant un espacement temporel différent, et/ou une énergie différente, et/ou une largeur d'impulsion différente, et/ou une puissance de crête différente.

6. Procédé selon la revendication 1, dans lequel ladite émission provoquée par ladite interaction initiale comprend un panache d'ablation produit par au moins une impulsion de la salve, ledit panache d'ablation interagissant avec une ou plusieurs impulsions consécutives de ladite salve pendant ladite autre interaction.

7. Procédé selon la revendication 1, dans lequel lesdites impulsions laser comprennent une durée d'impulsion inférieure à environ 500 ps.

8. Procédé selon la revendication 1, dans lequel chaque salve comprend 2-200 impulsions.

9. Procédé selon la revendication 1, dans lequel les impulsions dans la salve ont des longueurs d'onde dans le domaine spectral du proche infrarouge.

10. Procédé selon la revendication 1, dans lequel une séparation d'impulsions sélectionnée entre impulsions individuelles est inférieure à environ 1 µs.

11. Procédé selon la revendication 1, comprenant en outre la surveillance d'un courant ionique de plasma pendant l'ablation/le dépôt laser.

12. Procédé selon la revendication 1, dans lequel les matériaux en film mince comprennent des agrégats de nanoparticules, des films nanocomposites à nanoparticules intégrées, et un film lisse sans particules et sans gouttelettes.

13. Procédé selon la revendication 1 comprenant : la sélection d'une morphologie de film mince par sélection d'un paramètre de salve.

14. Procédé selon la revendication 1, dans lequel lesdits matériaux en film mince comprennent au moins un matériau choisi parmi un métal, un alliage, un oxyde métallique, un nitrure métallique, un fluorure métallique, un arséniure métallique, un sulfure métallique, un semi-conducteur, du carbone, du verre, un polymère, et un matériau composite.

15. Procédé selon la revendication 1, dans lequel lesdits matériaux en film mince comprennent une microstructure de phase amorphe ou cristalline, ou un mélange de phases à la fois amorphes et cristallines.

16. Procédé selon la revendication 1, dans lequel lesdits matériaux en film mince comportent des solutions solides ou des nanocomposites ou des structures de superréseaux de multiples matériaux formés en décapant alternativement ou simultanément différents matériaux cibles.

17. Procédé selon la revendication 1, dans lequel la salve est générée, au moins en partie, avec un modulateur acousto-optique (AOM) qui est utilisé pour la sélection d'impulsions dans un système d'amplification par compression d'impulsions (CPA), et la largeur de salve et la cadence de répétition de salve sont déterminées par une largeur de grille et une cadence de répétition de l'AOM, respectivement.
